# EUROPÄISCHE PATENTANMELDUNG

(11) **EP 3 787 002 A1**
(43) Veröffentlichungstag der Anmeldung: **03.03.2021**
(21) Anmeldenummer: 20192770.4
(22) Anmeldetag: 25.08.2020
(51) Int. Cl.: H01J 37/32, H01J 37/34

(54) **VORRICHTUNG UND VERFAHREN ZUM BESCHICHTEN ODER MODIFIZIEREN DER OBERFLÄCHE EINES SUBSTRATES INNERHALB EINER VAKUUMKAMMER**

(30) Priorität: 27.08.2019 DE 102019122972
(71) Anmelder: FRAUNHOFER-GESELLSCHAFT zur Förderung der angewandten Forschung e.V., 80686 München (DE)
(72) Erfinder: DR. TEMMLER, Dietmar, 01277 Dresden (DE); GOTTFRIED, Christian, 01277 Dresden (DE); DR. FRACH, Peter, 01277 Dresden (DE); DR. BARTZSCH, Hagen, 01277 Dresden (DE)

(57) **Zusammenfassung**

Die Erfindung betrifft eine Vorrichtung und ein Verfahren zum Beschichten oder Modifizieren der Oberfläche mindestens eines Substrates (11) innerhalb einer Vakuumkammer (10), wobei eine Blendenanordnung (13) zwischen einer Plasmaquelle (12) und dem Substrat (11) angeordnet wird und wobei die Blendenanordnung (13) mindestens 4 Blendenlamellen (14a; 14b; 14c; 14d; 14e; 14f) aufweist. Dabei wird mittels mindestens einer Stromversorgungseinrichtung (16) eine elektrische Spannung zwischen mindestens einer ersten Blendenlamelle (14a; 14c; 14e) und mindestens einer zweiten Blendenlamelle (14b; 14d; 14f) zumindest zeitweise erzeugt.

## Beschreibung

Die Erfindung betrifft eine Vorrichtung und eine Verfahren zum Beschichten oder Modifizieren der Oberfläche von Substraten innerhalb einer Vakuumkammer, wobei ein Plasma innerhalb der Vakuumkammer ausgebildet ist. Unter Modifizieren der Oberfläche von Substraten sollen erfindungsbezogen Prozesse verstanden werden, bei denen unter der Mitwirkung von Plasmapartikeln entweder die Struktur der Substratoberfläche und/oder die chemische Zusammensetzung des Substratmaterials an der Substratoberfläche verändert werden. Beispielhaft seien für das Verändern der Struktur einer Substratoberfläche das lonenätzen mittels Plasmaionen und für das Verändern der chemischen Zusammensetzung des Substratmaterials an der Substratoberfläche Prozesse angeführt, bei denen sich zum Beispiel ein Gas, ein Precursor oder ein Gemisch von Gasen und Precursoren innerhalb einer Vakuumkammer befindet, welche mittels eines Plasmas aufgespalten werden und infolgedessen chemische Elemente aus dem Gas bzw. dem Precursor an der Oberfläche des Substrates oder im oberflächennahen Bereich in das Substratmaterial eingebunden werden, wie es zum Beispiel beim Oxidieren oder Nitrieren der Fall ist.

Beim Abscheiden von Schichten oder dem Modifizieren von Festkörperoberflächen durch Plasmaprozesse ist ein Substrat, eine Interface Substrat-Schicht bzw. eine aufwachsende Schicht dem Bombardement unterschiedlicher Teilchen mit verschiedenen Energien ausgesetzt. Diese gleichzeitig auftreffenden Teilchen und Partikel können zum Beispiel aus Beschichtungsquellen, aus Gasen und aus einem Plasma innerhalb eines Reaktionsraumes stammen. Derartige Teilchen und Partikel können zum Beispiel Neutralteilchen, Ionen, Elektronen und Photonen sein. Die Energie dieser Teilchen reicht von wenigen Elektronenvolt bis hin zur Plasma-Brennspannung. Abhängig von der technologischen Zielstellung eines Plasmaprozesses sind einige Spezies aus dem Teilchengemisch und ihre Wirkungen vorteilhaft und deshalb erwünscht bzw. nachteilig und deshalb unerwünscht. Zum Beispiel ist das Bilden von Gitterdefekten durch implantierte Spezies im oberflächennahen Bereich einkristalliner oder organischer Halbleitersubstrate in der Regel unerwünscht, während der Beschuss aufwachsender Schichten mit höher energetischen Partikeln die Haftfestigkeit, Dichte und Festigkeit der Schichten deutlich verbessert, was deswegen oftmals erwünscht ist.

Für einen jeweiligen speziellen Plasmaprozess ist es vorteilhaft, wenn gewünschte Teilchen mit einer für den Zweck optimalen Energie auf ein Substrat bzw. die Deckschicht eines Substrates treffen, während gleichzeitig das Auftreffen unerwünschter Teilchen bzw. Partikel blockiert wird.

Für das Selektieren von Teilchen, welche bei einem Plasmaprozess bevorzugt auf ein Substrat auftreffen sollen bzw. für das Einstellen derer Energie und Anzahl sind aus dem Stand der Technik verschiedene Lösungen bekannt. So kann zunächst einmal eine Plasmaquelle entsprechend einer gewünschten Zielstellung zum Beispiel aus der Gruppe: DC-Magnetron, Puls-Magnetron, Hohlkathode oder Mikrowelle ausgewählt werden.

Ebenfalls bekannt ist es, ein Substrat mit einem Bias-Potenzial zu beaufschlagen, wodurch zum Beispiel die Energie von Ionen und Elektronen, welche auf das Substrat auftreffen, eingestellt werden kann. Neutralteilchen bleiben vom Bias-Potenzial hingegen unbeeinflusst. In DE 44 12 906 C1 wird zum Beispiel eine gepulste Bias-Spannung an ein elektrisch leitfähiges Substrat angelegt, um die Energie von auf das Substrat auftreffenden Ionen einzustellen.

Bei manchen Anwendungsfällen werden auch nachteilige Plasmawirkungen bei einer Schichtabscheidung in Kauf genommen und eine nachträgliche Ausheilung von Plasmaschäden beispielsweise durch Temperprozesse durchgeführt, wie zum Beispiel ein sogenannter H2-Anneal-Prozess nach Abschluss von Metallisierungs- und Passivierungsschritten bei integrierten Silizium-Schaltungen (Demaurex, et al., Damage at hydrogenated amorphous/crystalline silicon interfaces by indium tin oxide overlayer sputtering, Applied Physics Letters, Vol. 101, 2012, p. 171604-1-4). Hierfür ist dann jedoch ein zusätzlicher Prozessschritt erforderlich.

Eine Selektion von Teilchen wird auch bei Ionenimplantationsanlagen vorgenommen, bei denen eine Massetrenn-Einheit verwendet wird. Hierbei kann die Energie der auf ein Substrat auftreffenden Teilchen nahezu ideal eingestellt werden. Diese Vorgehensweise ist jedoch aufwendig und somit kostenintensiv.

Aus US 2001/0029894 A1 ist schließlich eine Vorrichtung bekannt, bei welcher eine Blende mit einer Vielzahl von Blendenlamellen zwischen einer Plasmaquelle und einem Substrat angeordnet ist, um den auf das Substrat auftreffenden Partikelfluss zu beeinflussen. Mittels einer solchen Blende wird jedoch lediglich die Flugbahn und Energie der Partikel verändert, welche auf eine Blendenlamelle auftreffen. Partikel, deren Flugbahn zwischen zwei Blendenlamellen hindurchführt, werden nicht von einer solchen Blende beeinflusst.

Eine Aufgabe der Erfindung besteht daher darin, eine Vorrichtung und ein Verfahren zu schaffen, mittels derer die Nachteile aus dem Stand der Technik überwunden werden können. Insbesondere solle es mit der erfindungsgemäßen Vorrichtung und dem erfindungsgemäßen Verfahren möglich sein, Spezies von Ladungsträgern, die auf ein Substrat auftreffen, zu selektieren, sowie deren elektrische Ladung und/oder deren Energie zu beeinflussen.

Die Lösung des technischen Problems ergibt sich durch Gegenstände mit den Merkmalen der Patentansprüche 1 und 10. Weitere vorteilhafte Ausgestaltungen der Erfindung ergeben sich aus den abhängigen Ansprüchen.

Eine erfindungsgemäße Vorrichtung zum Beschichten oder Modifizieren der Oberfläche mindestens eines Substrates innerhalb einer Vakuumkammer umfasst mindestens eine Plasmaquelle und eine sich zwischen der Plasmaquelle und dem Substrat befindende Blendenanordnung, welche mindestens vier Blendenlamellen aufweist. Als Plasmaquelle für eine erfindungsgemäße Vorrichtung ist zum Beispiel ein Sputtermagnetron, eine Hohlkathode oder ein Element zur Mikrowellen-Einkopplung geeignet. Des Weiteren umfasst eine erfindungsgemäße Vorrichtung mindestens eine Stromversorgungseinrichtung, mittels welcher eine elektrische Spannung zwischen mindestens einer ersten Blendenlamelle und mindestens einer zweiten Blendenlamelle zumindest zeitweise erzeugbar ist.

Vorzugsweise sind hierbei die Blendenlamellen elektrisch leitfähig und sowohl untereinander als auch gegenüber der Vakuumkammer elektrisch isoliert ausgebildet. Dadurch kann an den Blendenlamellen mittels mindestens einer Stromversorgungseinrichtung ein beliebiges und von den Vakuumkammerbestandteilen unabhängiges elektrisches Potenzial angelegt werden.

Das Ausbilden einer elektrischen Spannung zwischen mindestens einer ersten und einer zweiten Blendenlamelle bewirkt das Ausbilden eines elektrischen Feldes zwischen den beiden Lamellen, welches bewirkt, dass elektrisch geladene Plasmapartikel, welche sich von der Plasmaquelle hin zum Substrat bewegen, abgelenkt werden, sobald sie in den Bereich des elektrischen Feldes zwischen den Lamellen der Blende eintreten. Damit wird mindestens die Richtung und der Betrag der Geschwindigkeit der Plasmapartikel, damit ihre kinetische Energie verändert. Da positive Ionen von Lamellen mit negativem Potential und negative Ionen und Elektronen von Lamellen mit positivem Potential angezogen werden, kommt es, abhängig vom der Lamellengeometrie (Größe, Abstand, Anstellwinkel) und der Stärke des zwischen den Lamellen anliegenden elektrischen Feldes zum Auftreffen der geladenen Plasmapartikel auf die Lamellen, in einem Maß, das deutlich über dem liegt, das allein durch die Blendengeometrie ohne elektrische Feldwirkung bestimmt wird. Dadurch werden die Plasmaionen entladen und setzen ihren Weg als Neutralteilchen fort; Elektronen werden durch Entladen aus dem Partikelstrom zum Substrat eliminiert. Auf diese Weise ist es erfindungsgemäß möglich, den Partikelstrom zur Substratoberfläche hin zu verändern bzw. zu steuern.

Bei einer Ausführungsform wird eine erste Blendenlamelle und jede weitere zweite Blendenlamelle an einen elektrischen Pol einer als Gleichspannungsquelle ausgebildeten Stromversorgungseinrichtung angeschlossen und eine Blendenlamelle, welche unmittelbar mit der ersten Blendenlamelle benachbart ist, sowie jede weitere zweite Blendenlamelle an den anderen elektrischen Pol der Gleichspannungsquelle. Auf diese Weise entsteht eine Ausführungsform, bei der jede Blendenlamelle eine elektrische Potenzialdifferenz zu den unmittelbar benachbarten Blendenlamellen aufweist.

Eine für eine erfindungsgemäße Vorrichtung verwendete Stromversorgungseinrichtung kann ein Stellglied umfassen, mit dem die von der Stromversorgungseinrichtung erzeugte elektrische Spannung verändert werden kann, so dass die elektrische Potenzialdifferenz zwischen den Blendenlamellen veränderbar ist. Ein solches Stellglied kann zum Beispiel bewirken, dass die elektrische Spannung zwischen den Blendenlamellen erhöht bzw. verringert wird oder dass eine gepulste elektrische Spannung zwischen benachbarten Blendenlamellen anliegt. Das Verändern der elektrischen Potenzialdifferenz zwischen den Blendenlamellen während des Betriebes einer erfindungsgemäßen Vorrichtung bewirkt einen veränderten Partikelstrom zur Substratoberfläche hin, was zum Beispiel bei einer Schichtabscheidung zum Ausbilden einer Gradientenschicht verwendet werden kann.

Des Weiteren kann eine erfindungsgemäße Vorrichtung eine Einrichtung umfassen, mit welcher der Anstellwinkel der Blendenlamellen veränderbar ist. Als Anstellwinkel einer Blendenlamelle ist dabei der Winkel zwischen der Blendenlamellenfläche und der Oberfläche eines zu Beschichtenden oder zu modifizierenden Substrates zu verstehen.
Das Verändern des Anstiegswinkels der Blendenlamellen bewirkt ebenfalls einen veränderten Partikelfluss durch die Blendenanordnung hindurch hin zum Substrat, was bei einer Schichtabscheidung beispielsweise ebenfalls zum Ausbilden einer Gradientenschicht verwendet werden kann. Eine solche Einrichtung zum Verändern des Anstellwinkels kann zum Beispiel ein mechanisches Gestänge, einen elektrischen Antrieb und elektronische Bauelemente zum Zu- und Abschalten bzw. zum Verändern der elektrischen Spannung am elektrischen Antrieb umfassen.

Der Partikelstrom ausgehend vom Plasma innerhalb der Vakuumkammer einer erfindungsgemäßen Vorrichtung hin zum Substrat kann umso detaillierter gesteuert bzw. eingestellt werden, je höher die Anzahl der verwendeten Blendenlamellen gewählt wird. Da sich der Partikelstrom zum Substrat bei vielen Anwendungsfällen bereits mit vier Blendenlamellen hinreichend gut regeln bzw. einstellen lässt, weist eine erfindungsgemäße Blendenanordnung mindestens vier Blendenlamellen auf.

Bei einer weiteren Ausführungsform ist mindestens eine Ausdehnung der Blendenlamellen parallel zur Substratoberfläche ausgerichtet. Vorzugsweise ist die Längsausdehnung der Blendenlamellen parallel zur Substratoberfläche ausgerichtet.

Die Blendenanordnung und deren Blendenlamellen können unterschiedliche Formen aufweisen. So kann die Form der Blendenlamellen einer Blendenanordnung rechteckig sein, wobei die Blendenlamellen mit einem gleichen Maß voneinander beabstandet sind und wobei alle Blendenlamellen einen identischen Anstellwinkel aufweisen, der optional veränderbar sein kann. Bei identischem Anstellwinkel sind somit die Flächen der Blendenlamellen parallel zueinander ausgerichtet. Wenn bei einer solchen Blendeneinrichtung alle Blendenlamellen eine identische Länge aufweisen, kann eine solche Blendenanordnung rechteckig ausgebildet sein.

Alternativ kann eine Blendenanordnung aber auch kreisförmig und die Blendenlamellen als Kreissektoren ausgebildet sein.

Bevorzugt ist eine erfindungsgemäße Vorrichtung für das Beschichten oder Modifizieren von Substraten mit einer ebenen Oberfläche geeignet, wobei die Blendenlamellen bei einer Ausführungsform ebene Lamellenflächen aufweisen. Alternativ können die Lamellenflächen auch eine gebogene oder gewölbte Form aufweisen.
Eine erfindungsgemäße Vorrichtung ist aber auch zum Beschichten oder Modifizieren von Substraten geeignet, welche keine ebene Oberfläche aufweisen. Auch hierbei können die Blendenlamellen entweder eine ebene Lamellenfläche oder alternativ eine gebogene oder gewölbte Fläche bzw. eine Flächenform aufweisen, welche zum Beispiel der Oberfläche des zu Beschichtenden oder zu modifizierenden Substrates entspricht.

Beim erfindungsgemäßen Verfahren zum Beschichten oder Modifizieren der Oberfläche mindestens eines Substrates innerhalb einer Vakuumkammer wird eine Blendenanordnung zwischen einer Plasmaquelle und dem Substrat angeordnet, wobei die Blendenanordnung mindestens 4 Blendenlamellen aufweist. Des Weiteren wird mittels mindestens einer Stromversorgungseinrichtung eine elektrische Spannung zwischen mindestens einer ersten Blendenlamelle und mindestens einer zweiten Blendenlamelle zumindest zeitweise erzeugt.

Die Erfindung wird nachfolgend anhand von Ausführungsbeispielen näher beschrieben. Die Fig. zeigen:
- Fig. 1: eine schematische Schnittdarstellung einer erfindungsgemäßen Vorrichtung;
- Fig. 2: eine schematische Schnittdarstellung der Blendenanordnung aus Fig. 1;
- Fig. 3: eine schematische Perspektivdarstellung einer kreisförmigen Blendenanordnung;
- Fig. 4: eine schematische Darstellung von Partikelflugbahnen durch eine erfindungsgemäße Blendenanordnung.

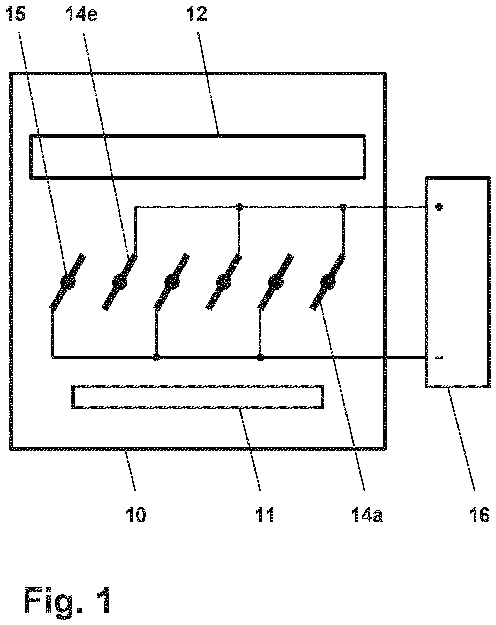

In Fig. 1 ist eine erfindungsgemäße Vorrichtung schematisch dargestellt. Innerhalb einer Vakuumkammer 10 befindet sich ein Substrat 11, dessen Oberfläche mittels einer Plasmaquelle 12 beschichtet oder modifiziert werden soll, wobei sich Ionen, Elektronen, Neutralteilchen und/oder Schichtmaterialpartikel von der Plasmaquelle 12 hin zur Oberfläche des Substrates 11 bewegen. Die Plasmaquelle 12 kann beispielsweise als Sputtermagnetron, als Hohlkathode oder als Element zur Mikrowellen-Einkopplung ausgebildet sein.

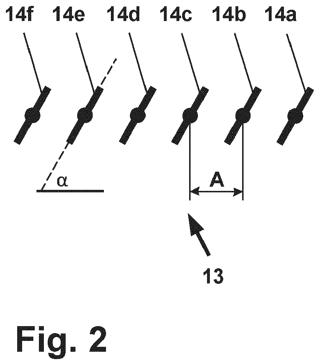

Zwischen der Plasmaquelle 12 und dem Substrat 11 befindet sich erfindungsgemäß eine Blendenanordnung. Diese Blendenanordnung ist in Fig. 2 noch einmal separat als Blendenanordnung 13 schematisch in einem Schnitt dargestellt. Die Blendenanordnung 13 umfasst sechs Blendenlamellen 14a bis 14f, welche eine identische rechteckige Lamellenfläche und einen identischen Anstellwinkel a aufweisen und welche jeweils um eine Achse 15, welche sich in die Tiefe der Fig. 1 und 2 erstreckt, drehbar gelagert sind. Der Anstellwinkel a der Blendenlamellen 14a bis 14f kann somit zum Beispiel während des Beschichtens oder Modifizierens der Oberfläche des Substrates 11 verändert werden. Der Anstellwinkel a der Blendenlamellen 14a bis 14f kann zum Beispiel von 0° bis 90° stufenlos verändert werden. Im Ausführungsbeispiel wurden die Abmaße und Abstände der Blendenlamellen 14a bis 14f derart gewählt, dass die Blendenanordnung 13 bei einem Anstellwinkel a = 0° die Blendenanordnung 13 in Richtung zur Plasmaquelle 12 optisch geschlossen ist. Bei einer anderen Dimensionierung der Blendenlamellen und/oder deren Abstand zueinander kann eine erfindungsgemäße Blendenanordnung aber auch schon bei einem Anstellwinkel größer als 0° in Richtung der Plasmaquelle optisch geschlossen sein. Bei einem Anstellwinkel a von 90° sind die Blendenlamellen 14a bis 14f im beschriebenen Ausführungsbeispiel senkrecht zur Oberfläche des Substrates 11 ausgerichtet. Alternativ kann ein Anstellwinkel a aber auch vor einem Prozess des Beschichtens oder Modifizierens fest eingestellt und während des gesamten Prozesses beibehalten werden.

Die Achsen 15 der Blendenlamellen 14a bis 14f sind mit einem identischen Maß A voneinander beabstandet. Die Ebene, in welcher sich alle Achsen 15 befinden, ist parallel zur Oberfläche des Substrates 11 ausgerichtet. Somit ist auch die Längsausdehnung der Blendenlamellen 14a bis 14f, welche sich in die Tiefe der Fig. 1 und 2 erstreckt, parallel zur Oberfläche des Substrates 11 ausgerichtet.

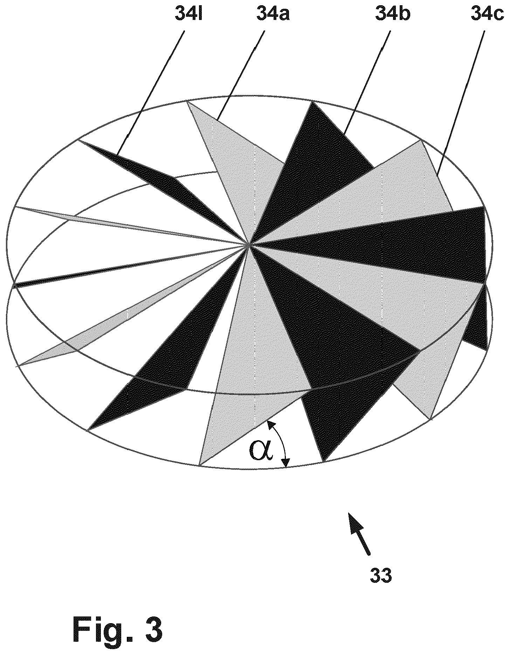

In Fig. 3 ist eine Ausführungsform einer erfindungsgemäßen, kreisförmigen Blendenanordnung 33 in einer Perspektivdarstellung abgebildet. Die Blendenlamellen 34a bis 34l der Blendenanordnung 33 sind als Kreissegmente ausgebildet und weisen einen Anstellwinkel a auf, der ebenfalls von 0° bis 90° fest eingestellt oder alternativ während eines Prozesses des Beschichtens oder Modifizierens eines Substrates verändert werden kann. Eine solche Blendenanordnung kann beispielsweise vorteilhaft bei einer erfindungsgemäßen Vorrichtung verwendet werden, wenn ein Substrat zum Beispiel mittels eines kreisförmigen oder ringförmigen Sputtermagnetrons beschichtet oder modifiziert werden soll.

Erfindungsgemäß wird auch bei der Blendenanordnung 33 zumindest zwischen einer ersten Blendenlamelle und einer zweiten Blendenlamelle eine elektrische Spannung mittels mindestens einer Stromversorgungseinrichtung geschaltet. Vorzugsweise ist bei einer Blendenanordnung, wie Blendenanordnung 33, eine erste Blendenlamelle 34a und jede weitere zweite Blendenlamelle, wie beispielsweise Blendenlamelle 34c (und somit die Blendenlamellen mit einer in Fig. 3 hell dargestellten Lamellenfläche), mit einem Pol einer als Gleichspannungsquelle ausgebildeten Stromversorgungseinrichtung verbunden und eine unmittelbar mit der Blendenlamelle 34a benachbarte Blendenlamelle 34b und jede weitere zweite Blendenlamelle, wie zum Beispiel Blendenlamelle 34l (und somit die Blendenlamellen mit einer in Fig. 3 dunkel dargestellten Lamellenfläche), mit dem anderen Pol der Stromversorgungseinrichtung verbunden. Dabei kann die von der Stromversorgungseinrichtung bereitgestellte elektrische Spannung während eines Prozesses des Beschichtens oder des Modifizierens eines Substrates konstant gehalten oder alternativ auch verändert werden.

Wie schon zuvor dargelegt wurde, kann bei einer erfindungsgemäßen Vorrichtung mittels einer Blendenanordung der durch die Blendenanordnung hindurch gelangende Partikelstrom zu einer Substratoberfläche verändert und gesteuert werden. Zum einen lässt sich der Partikelstrom in Abhängigkeit vom Anstellwinkelader Blendenlamellen verändern, wobei die Durchlassöffnungen durch die Blendenanordnung hindurch bei einem verkleinerten Anstellwinkel a verringert oder bei einem vergrößerten Anstellwinkel a vergrößert werden. Zum anderen kann der Partikelstrom aber auch separat oder zusätzlich durch die elektrische Spannung, welche zwischen benachbarte Blendenlamellen angelegt wird, beeinflusst werden, wobei Partikel mit unterschiedlicher elektrischer Ladung auch eine unterschiedliche Beeinflussung durch das elektrische Feld zwischen den Blendenlamellen erfahren.

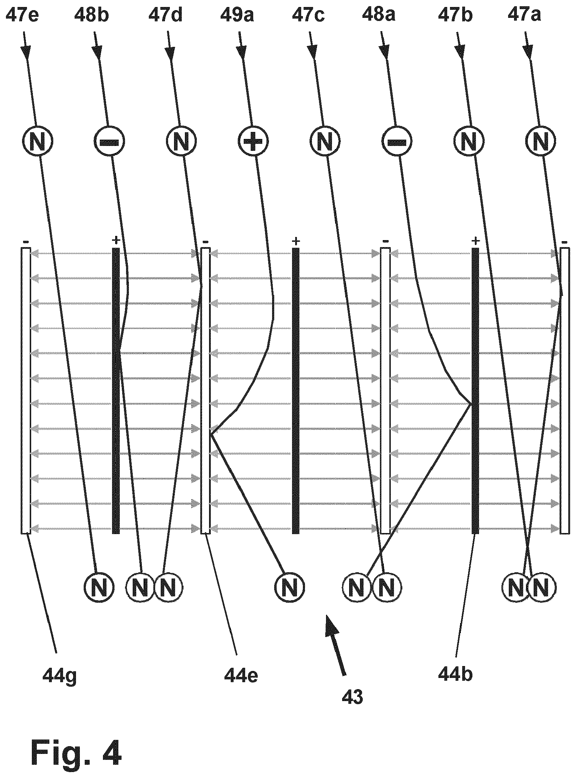

In Fig. 4 sind beispielhafte Partikelflugbahnen durch eine Blendenanordnung 43 hindurch schematisch dargestellt. Die Blendenanordnung 43 umfasst mehrere, eben geformte Blendenlamellen, welche einen Anstellwinkel von 90° aufweisen und somit senkrecht zu einer in Fig. 4 nicht dargestellten Substratoberfläche ausgerichtet sind. Hierbei sind die schwarz ausgefüllten Blendenlamellen, wie Blendenlamelle 44b, mit dem Plus-Pol einer als Gleichspannungsquelle ausgebildeten Stromversorgungseinrichtung verbunden und die Blendenlamellen ohne Farbfüllung, wie die Blendenlamellen 44e und 44g, an den Minus-Pol der Stromversorgungseinrichtung, so dass eine Potenzialdifferenz zwischen den jeweils unmittelbar benachbarten Blendenlamellen ausgebildet wird. Das hierbei entstehende elektrische Feld wird durch die waagerechten Pfeile veranschaulicht.

Die Partikelflugbahnen mit den Bezugszeichen 47a, 47b, 47c, 47d und 47e stellen die Flugbahnen von Neutralteilchen, die Partikelflugbahnen mit den Bezugszeichen 48a und 48b stellen die Flugbahnen von negativ geladenen Ionen und Elektronen und die Partikelflugbahn mit dem Bezugszeichen 49a stellt die Flugbahn eines positiv geladenen Ions dar.

Anhand der Partikelflugbahn 47b ist ersichtlich, dass die Flugbahn von Neutralteilchen keine Beeinflussung durch das elektrische Feld zwischen den Blendenlamellen erfahren. Eine Neutralteilchen-Flugbahn wird entscheidend beeinflusst, wenn es auf eine Blendenlamelle auftrifft, wobei es üblicherweise Energie verliert und entweder von der Blendenlamelle abprallt (wie bei Flugbahn 47a ersichtlich) oder an der Blendenlamelle haften bleibt. Elektronen, negativ und positiv geladene Ionen erfahren in Ihrer Flugbahn mindestens eine Ablenkung durch das elektrische Feld zwischen den Blendenlamellen als auch eine Entladung (Neutralisierung) und Richtungsveränderung, wenn diese auf eine Blendenlamelle auftreffen und abprallen, wie es bei den Flugbahnen 48a und 49a dargestellt ist. Dabei geht bei einem Aufprall üblicherweise Energie verloren, Elektronen treten in die elektrisch leitfähige Blende ein, werden beim Auftreffen auf eine positive Lamelle eliminiert, während Ionen überwiegend entladen werden und ihre Flugbahn als Neutralteilchen fortsetzen.

In Abhängigkeit von der Lamellengröße, vom Lamellenabstand und dem Anstellwinkel wird ab einer bestimmten Potenzialdifferenz zwischen benachbarten Blendenlamellen jeder elektrisch geladene Partikel zum Aufprall und damit zur Entladung an den Blendenlamellen gebracht, so dass das Auftreffen elektrisch geladener Partikel auf das Substrat vollständig verhindert wird. Die dafür notwendige Potenzialdifferenz ist proportional zur maximalen Energie, die Partikel bei der Plasmaentladung aufnehmen können.

Durch den Anstellwinkel der Blendenlamellen sowie die Höhe der elektrischen Potenzialdifferenz zwischen den Blendenlamellen kann somit eingestellt werden, welche Partikel hinsichtlich ihrer Ladung, Energie und ihrer Flugbahn durch eine Blendenanordnung hindurch beeinflusst werden und wie stark diese Beeinflussung ausfallen soll.

## Patentansprüche

1. Vorrichtung zum Beschichten oder Modifizieren einer Oberfläche mindestens eines Substrates (11) innerhalb einer Vakuumkammer (10), umfassend mindestens eine Plasmaquelle (12) und eine sich zwischen der Plasmaquelle (12) und dem Substrat (11) befindende Blendenanordnung (13), welche mindestens vier Blendenlamellen (14a; 14b; 14c; 14d; 14e; 14f) aufweist, **gekennzeichnet durch** mindestens eine Stromversorgungseinrichtung (16), mittels welcher eine elektrische Spannung zwischen mindestens einer ersten Blendenlamelle (14a, 14c; 14e) und mindestens einer zweiten Blendenlamelle (14b; 14d; 14f) zumindest zeitweise erzeugbar ist.

2. Vorrichtung nach Anspruch 1, **dadurch gekennzeichnet, dass** die Blendenlamellen (14a; 14b; 14c; 14d; 14e; 14f) elektrisch leitfähig und sowohl untereinander als auch gegenüber der Vakuumkammer (10) elektrisch isoliert ausgebildet sind.

3. Vorrichtung nach Anspruch 1 oder 2, **dadurch gekennzeichnet, dass** jede Blendenlamelle eine elektrische Potenzialdifferenz zu den unmittelbar benachbarten Blendenlamellen aufweist.

4. Vorrichtung nach Anspruch 3, **gekennzeichnet durch** mindestens ein Stellglied, mittels dessen die elektrische Potenzialdifferenz veränderbar ist.

5. Vorrichtung nach einem der vorhergehenden Ansprüche, **dadurch gekennzeichnet, dass** mindestens eine Ausdehnung der Blendenlamellen (14a; 14b; 14c; 14d; 14e; 14f) parallel zur Substratoberfläche ausgerichtet ist.

6. Vorrichtung nach einem der vorhergehenden Ansprüche, **gekennzeichnet durch** eine Einrichtung, mittels welcher der Anstellwinkel der Blendenlamellen veränderbar ist.

7. Vorrichtung nach einem der Ansprüche 1 bis 6, **dadurch gekennzeichnet, dass** die Blendenlamellen (14a; 14b; 14c; 14d; 14e; 14f) entlang einer Ausdehnung parallel zueinander ausgerichtet sind.

8. Vorrichtung nach einem der Ansprüche 1 bis 6, **dadurch gekennzeichnet, dass** die Blendenanordnung (33) kreisförmig ist und die Blendenlamellen (34a; 34b; 34c; 34l) als Kreissektoren ausgebildet sind.

9. Vorrichtung nach einem der vorhergehenden Ansprüche, **dadurch gekennzeichnet, dass** die mindestens eine Stromversorgungseinrichtung (16) als Gleichspannungsquelle ausgebildet ist.

10. Verfahren zum Beschichten oder Modifizieren einer Oberfläche mindestens eines Substrates (11) innerhalb einer Vakuumkammer (10), wobei eine Blendenanordnung (13) zwischen einer Plasmaquelle (12) und dem Substrat (11) angeordnet wird und wobei die Blendenanordnung (13) mindestens 4 Blendenlamellen (14a; 14b; 14c; 14d; 14e; 14f) aufweist, **dadurch gekennzeichnet, dass** mittels mindestens einer Stromversorgungseinrichtung (16) eine elektrische Spannung zwischen mindestens einer ersten Blendenlamelle (14a; 14c; 14e) und mindestens einer zweiten Blendenlamelle (14b; 14d; 14f) zumindest zeitweise erzeugt wird.
